# EUROPEAN PATENT APPLICATION

(11) **EP 4 730 314 A1**
(43) Date of publication of application: **22.04.2026**
(21) Application number: 23950034.1
(22) Date of filing: 28.08.2023
(51) Int. Cl.: G09G 3/3208, H10D 1/20

(54) **DISPLAY SUBSTRATE AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: SONG, Gukhwan, Beijing 100176 (CN); GAO, Wenhui, Beijing 100176 (CN); GUO, Yonglin, Beijing 100176 (CN); ZHANG, Tiaomei, Beijing 100176 (CN); LEE, Youngjang, Beijing 100176 (CN); HU, Ming, Beijing 100176 (CN)
(74) Representative: Isarpatent
(86) International application number: PCT/CN2023/115260
(87) International publication number: WO 2025/043440

(57) **Abstract**

A display substrate and a display device are provided. The display substrate includes a first light emitting control signal line, a second light emitting control signal line and a plurality of sub-pixels; the sub-pixel includes a sub-pixel driving circuit and a light emitting element, the sub-pixel driving circuit includes a driving transistor, a power control transistor and a light emitting control transistor; a gate electrode of the power control transistor is coupled to a corresponding first light emitting control signal line, a first electrode of the power control transistor is coupled to a corresponding power line, and a second electrode of the power control transistor is coupled to a first electrode of the driving transistor, a gate electrode of the light emitting control transistor is coupled to a corresponding second light emitting control signal line, and a first electrode of the light emitting control transistor is connected to a second electrode of the driving transistor, and a second electrode of the light emitting control transistor is coupled to the light emitting element; an orthographic projection of the first light emitting control signal line on the base substrate and an orthographic projection of the second light emitting control signal line on the base substrate are arranged along a second direction.

## Description

### TECHNICAL FIELD

The present disclosure relates to the field of display technology, in particular to a display substrate and a display device.

### BACKGROUND

In recent years, with the rapid development of the display industry, rigid liquid crystal displays (LCD) have gradually been unable to meet people's pursuit of life. Therefore, organic light emitting diodes (OLED) display came into being, which are famous for their flexibility, and no matter what kind of display products, consumers have put forward higher requirements for the image quality of the display products.

### SUMMARY

In one aspect, the present disclosure provides in some embodiments a display substrate, including: a base substrate, a power line, a first light emitting control signal line, a second light emitting control signal line and a plurality of sub-pixels all arranged on the base substrate; wherein the sub-pixel includes a sub-pixel driving circuit and a light emitting element, the sub-pixel driving circuit includes a driving transistor, a power control transistor and a light emitting control transistor; a gate electrode of the power control transistor is coupled to a corresponding first light emitting control signal line, a first electrode of the power control transistor is coupled to a corresponding power line, and a second electrode of the power control transistor is coupled to a first electrode of the driving transistor, a gate electrode of the light emitting control transistor is coupled to a corresponding second light emitting control signal line, and a first electrode of the light emitting control transistor is connected to a second electrode of the driving transistor, and a second electrode of the light emitting control transistor is coupled to the light emitting element; the first light emitting control signal line includes at least part extending along a first direction, the second light emitting control signal line includes at least part extending along the first direction, and an orthographic projection of the first light emitting control signal line on the base substrate and an orthographic projection of the second light emitting control signal line on the base substrate are arranged along a second direction, and the second direction intersects the first direction.

Optionally, the power control transistor includes a power control active layer, the light emitting control transistor includes a light emitting control active layer, and the power control active layer and the light emitting control active layer are arranged along the first direction.

Optionally, in a layout area of a same sub-pixel driving circuit, at least part of the orthographic projection of the first light emitting control signal line on the base substrate is located between an orthographic projection of the gate electrode of the driving transistor on the base substrate and the orthographic projection of the second light emitting control signal line on the base substrate.

Optionally, at least part of an orthographic projection of the gate electrode of the power control transistor on the base substrate, and/or, at least part of an orthographic projection of the gate electrode of the light emitting control transistor on the base substrate is located between the orthographic projection of the first light emitting control signal line on the base substrate and the orthographic projection of the second light emitting control signal line on the base substrate.

Optionally, the display substrate further includes a first scanning line and a data line; the sub-pixel driving circuit includes a data writing-in transistor, a gate electrode of the data writing-in transistor is coupled to a corresponding first scanning line, a first electrode of the data writing-in transistor is coupled to a corresponding data line, and a second electrode of the data writing-in transistor is coupled to the first electrode of the driving transistor; in a layout area of a same sub-pixel driving circuit, at least part of an orthographic projection of the first scanning line on the base substrate is located between the orthographic projection of the first light emitting control signal line on the base substrate and the orthographic projection of the second light emitting control signal line on the base substrate.

Optionally, the orthographic projection of the first scanning line on the base substrate does not overlap the orthographic projection of the first light emitting control signal line on the base substrate; and/or, the orthographic projection of the first scanning line on the base substrate does not overlap the orthographic projection of the second light emitting control signal line on the base substrate.

Optionally, the data writing-in transistor includes a data writing-in active layer, the power control transistor includes a power control active layer, and the driving transistor includes a driving active layer; a first end of the data writing-in active layer, a first end of the power control active layer and a first end of the driving active layer are coupled to each other to form a second node portion; at least part of the data writing-in active layer and at least part of the power control active layer are located on a same side of the driving active layer along the second direction.

Optionally, the sub-pixel driving circuit further includes a storage capacitor, a first electrode plate of the storage capacitor is coupled to the gate electrode of the driving transistor, and a second electrode plate of the storage capacitor is coupled to the power line; the second electrode plate includes an electrode plate main portion and an electrode plate extension portion coupled to each other, an orthographic projection of the electrode plate main portion on the base substrate partially overlaps an orthographic projection of the first electrode plate on the base substrate, an orthographic projection of the electrode plate extension portion on the base substrate does not overlap the orthographic projection of the first electrode plate on the base substrate, the orthographic projection of the electrode plate extension portion on the base substrate at least partially overlaps an orthographic projection of the second node portion on the base substrate.

Optionally, the orthographic projection of the electrode plate extension portion on the base substrate partially overlaps the orthographic projection of the first light emitting control signal line on the base substrate, and does not overlap the orthographic projection of the second light emitting control signal line on the base substrate.

Optionally, the sub-pixel driving circuit further includes a first conductive connection portion, and the first conductive connection portion is respectively connected to the first electrode of the power control transistor, the electrode plate extension portion and the power line; an orthographic projection of the first conductive connection portion on the base substrate does not overlap the orthographic projection of the electrode plate main portion on the base substrate.

Optionally, the power line includes at least part extending along the second direction; there is a first overlapping area between the orthographic projection of the power line on the base substrate and the orthographic projection of the first light emitting control signal line on the base substrate, and there is a second overlapping area between the orthographic projection of the power line on the base substrate and the orthographic projection of the second light emitting control signal line on the base substrate; a length of the first overlapping area along the first direction is greater than a length of the second overlapping area along the first direction.

Optionally, the first light emitting control signal line and the gate electrode of the power control transistor are arranged in different layers; and/or, the second light emitting control signal line and the gate electrode of the light emitting control transistors are arranged in different layers.

Optionally, the display substrate further includes a first source-drain metal layer, the first light emitting control signal line and/or the second light emitting control signal line, and the first source-drain metal layers are arranged in a same layer and made of a same material.

Optionally, the display substrate further comprises a first initialization signal transmission layer, the first initialization signal transmission layer includes a plurality of first initialization transmission portions and a plurality of second initialization transmission portions, an extension direction of the first initialization transmission portions intersects an extension direction of the second initialization transmission portion; at least part of the sub-pixel driving circuit also includes a first reset transistor and a second conductive connection portion, the second conductive connection portion is respectively coupled to a first electrode of the first reset transistor, a corresponding first initialization transmission portion and a corresponding second initialization transmission portion; a second electrode of the first reset transistor is coupled to the gate electrode of the driving transistor.

Optionally, the display substrate further includes a second initialization signal transmission layer, the second initialization signal transmission layer includes a plurality of third initialization transmission portions and a plurality of fourth initialization transmission portions, an extension direction of the third initialization transmission portion intersects an extension direction of the fourth initialization transmission portion; at least part of the sub-pixel driving circuit also includes a second reset transistor and an eighth conductive connection portion, the eighth conductive connection portion is respectively coupled to the a electrode of the second reset transistor, a corresponding third initialization transmission portion and a corresponding fourth initialization transmission portion; a second electrode of the second reset transistor is coupled to the light emitting element.

Optionally, the display substrate further includes a cathode layer and a plurality of first cathode compensation lines, the first cathode compensation line includes at least part extending along the second direction, the plurality of the first cathode compensation lines are respectively coupled to the cathode layer.

Optionally, the first initialization transmission portion and the third initialization transmission portion are alternately arranged along the second direction; and/or the second initialization transmission portions and the fourth initialization transmission portions are alternately arranged along the first direction; and/or, at least part of the first cathode compensation line is located between adjacent second initialization transmission portion and fourth initialization transmission portion.

Optionally, the display substrate includes a plurality of power lines and a plurality of data lines; the second initialization transmission portion is located between adjacent power line and data line; and/or the fourth initialization transmission portion is located between adjacent power line and data line; and/or, the first cathode compensation line is located between adjacent power supply line and data line; the adjacent power line and data line are coupled to a same sub-pixel driving circuit.

Optionally, the display substrate further includes a plurality of second cathode compensation lines arranged along the second direction, and the second cathode compensation line includes at least part extending along the first direction, the second cathode compensation line is coupled to the first cathode compensation line.

Optionally, the display substrate further includes a plurality of power supply compensation lines, the power supply compensation line includes at least part extending along the first direction, the power supply compensation line is coupled to the power line; the power compensation line and the second cathode compensation line are alternately arranged along the second direction.

Optionally, the first reset transistor includes a first reset active layer, and the first reset active layer includes two first channel portions, and a first conductive portion respectively coupled to the two first channel portions; an orthographic projection of the first conductive portion on the base substrate at least partially overlaps an orthographic projection of the third initialization transmission portion on the base substrate.

Optionally, the sub-pixel driving circuit further includes a compensation transistor, and a first electrode of the compensation transistor is coupled to the second electrode of the driving transistor, a second electrode of the compensation transistor is coupled with the gate electrode of the driving transistor; the compensation transistor includes a compensation active layer, the compensation active layer includes two second channel portions, and a second conductive portion respectively coupled to the two second channel portions; an orthographic projection of the second conductive portion on the base substrate at least partially overlaps the orthographic projection of the first initialization transmission portion on the base substrate.

In a second aspect, an embodiment of the present disclosure provides a display device, including the display substrate.

### BRIEF DESCRIPTION OF THE DRAWINGS

The drawings described here are configured to provide a further understanding of the present disclosure and constitute a part of the present disclosure. The illustrative embodiments of the present disclosure and their descriptions are configured to explain the present disclosure and do not constitute an improper limitation of the present disclosure
FIG. 1 is a schematic diagram of a circuit structure of a sub-pixel driving circuit according to an embodiment of the present disclosure;
FIG. 2 is a driving timing diagram of a sub-pixel driving circuit according to an embodiment of the present disclosure;
FIG. 3 is a schematic cross-sectional view of a film layer of a display substrate according to an embodiment of the present disclosure;
FIG. 4 is a schematic layout diagram of an active layer of a display substrate according to an embodiment of the present disclosure;
FIG. 5 is a schematic layout diagram of the active layer and the first gate metal layer of the display substrate according to an embodiment of the present disclosure;
FIG. 6 is a schematic layout diagram of the second gate metal layer of the display substrate according to an embodiment of the present disclosure;
FIG. 7 is a schematic layout diagram of a second gate metal layer added on the basis of FIG. 5;
FIG. 8 is a schematic diagram of a via hole formed on an interlayer insulating layer of a display substrate according to an embodiment of the present disclosure;
FIG. 9 is a schematic first layout diagram of the first source-drain metal layer of the display substrate according to an embodiment of the present disclosure;
FIG. 10 is a schematic layout diagram of a first source-drain metal layer added on the basis of FIG. 5;
FIG. 11 is a schematic layout diagram of the second gate metal layer and the first source-drain metal layer of the display substrate according to an embodiment of the present disclosure;
FIG. 12 is a schematic layout diagram of a first source-drain metal layer of a display substrate according to an embodiment of the present disclosure added on the basis of FIG. 7;
FIG. 13 is a schematic diagram of the first layout of via holes formed on the first planarization layer of the display substrate according to an embodiment of the present disclosure;
FIG. 14 is a schematic diagram of the first layout of the second source-drain metal layer of the display substrate according to an embodiment of the present disclosure;
FIG. 15 is a schematic layout diagram of via holes formed on the second planarization layer of the display substrate according to an embodiment of the present disclosure;
FIG. 16 is a schematic diagram of the first layout of the first source-drain metal layer and the second source-drain metal layer of the display substrate according to an embodiment of the present disclosure;
FIG. 17 is a schematic layout diagram of a second source-drain metal layer added on the basis of FIG. 11;
FIG. 18 is a schematic layout diagram of a second source-drain metal layer added on the basis of FIG. 12;
FIG. 19 is a schematic diagram of the second layout of the first source-drain metal layer of the display substrate according to an embodiment of the present disclosure;
FIG. 20 is a schematic diagram of the second layout of the via holes formed on the first planarization layer of the display substrate according to an embodiment of the present disclosure;
FIG. 21 is a schematic diagram of the second layout of the second source-drain metal layer of the display substrate according to an embodiment of the present disclosure;
FIG. 22 is a schematic diagram of the second layout of the first source-drain metal layer and the second source-drain metal layer of the display substrate according to an embodiment of the present disclosure.

### DETAILED DESCRIPTION

In order to further explain the display substrate and display device provided by the embodiments of the present disclosure, a detailed description will be given below with reference to the accompanying drawings.

The display quality of a display product is related to the circuit structure and working status of the sub-pixel driving circuit included in the display product. In the related art, the driving transistor in the sub-pixel driving circuit has hysteresis, and the problem of frequency switching flicker in display products has not been improved.

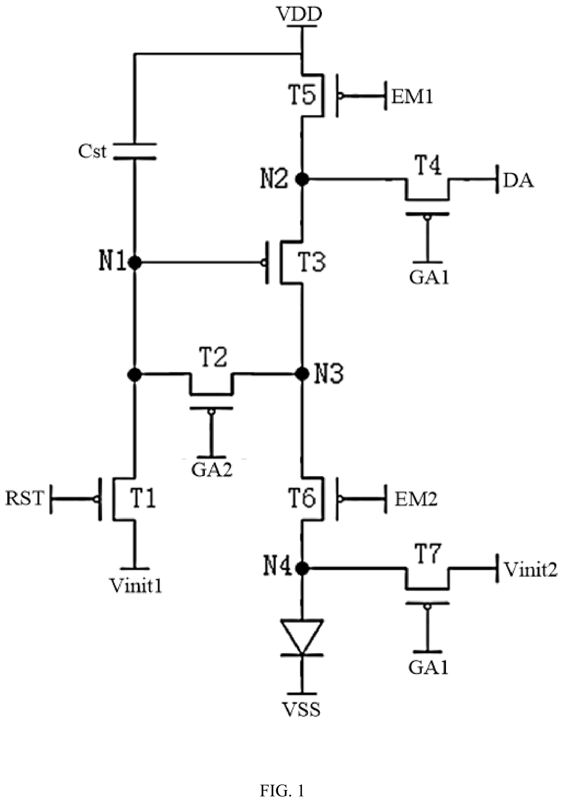

As shown in FIG. 1, the present disclosure provides a display substrate. The display substrate includes a plurality of sub-pixels, and the sub-pixels include a sub-pixel driving circuit and a light emitting element coupled to each other. The display substrate also includes: a plurality of first light emitting control signal lines EM1, a plurality of second light emitting control signal lines EM2, a plurality of first scanning lines GA1, a plurality of second scanning lines GA2, and a plurality of reset signal lines RST, a plurality of power lines VDD, a plurality of data lines DA, a first initialization signal transmission layer Vinit1, a second initialization signal transmission layer Vinit2 and a cathode layer.

Exemplarily, the display substrate includes a plurality of sub-pixels, and a plurality of sub-pixel driving circuits included in the plurality of sub-pixels are arranged in an array. The plurality of sub-pixel driving circuits are divided into a plurality of rows of sub-pixel driving circuits and a plurality of columns of sub-pixel driving circuits. The plurality of rows of sub-pixel driving circuits are arranged along the second direction, and each row of sub-pixel driving circuits includes a plurality of sub-pixel driving circuits arranged along the first direction. The plurality of columns of sub-pixel driving circuits are arranged along a first direction, and each column of sub-pixel driving circuits includes a plurality of sub-pixel driving circuits arranged along a second direction. Illustratively, the first direction and the second direction intersect. For example: the first direction includes the transverse direction, and the second direction includes the longitudinal direction.

Exemplarily, the sub-pixel includes a sub-pixel driving circuit and a light emitting element. The sub-pixel driving circuit is coupled to the anode of the light emitting element and is configured to provide a driving signal to the light emitting element and drive the light emitting element to emit light.

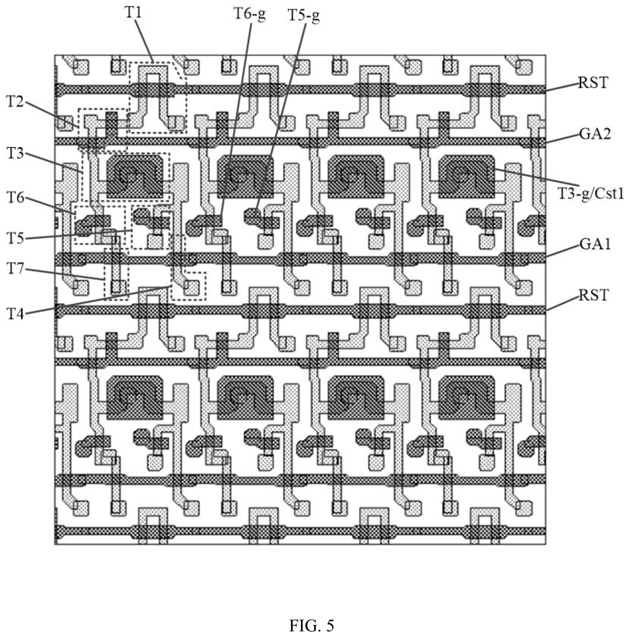

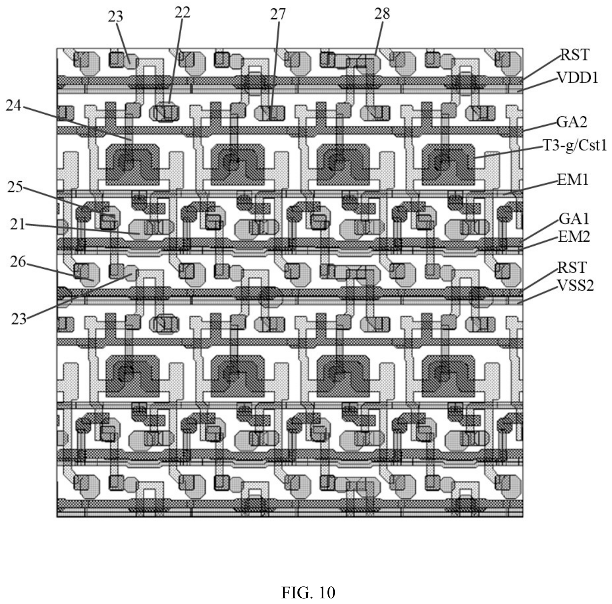

As shown in FIGS. 5, 9, 10 and 11, for example, the plurality of first light emitting control signal lines EM1 correspond to the plurality of rows of sub-pixel driving circuits in a one-to-one manner, and the first light emitting control signal lines EM1 is respectively coupled to each sub-pixel driving circuit in a corresponding row of sub-pixel driving circuits.

Exemplarily, the plurality of second light emitting control signal lines EM2 correspond to the plurality of rows of sub-pixel driving circuits in a one-to-one manner, and the second light emitting control signal lines EM2 are coupled to each sub-pixel driving circuit in the corresponding row of sub-pixel driving circuits.

Exemplarily, the plurality of first scanning lines GA1 correspond to the plurality of rows of sub-pixel driving circuits in a one-to-one manner, and the first scanning line GA1 is respectively coupled to each sub-pixel driving circuit in the corresponding row of sub-pixel driving circuits.

Exemplarily, the plurality of second scanning lines GA2 correspond to the plurality of rows of sub-pixel driving circuits in a one-to-one manner, and the second scanning lines GA2 are respectively coupled to each sub-pixel driving circuit in the corresponding row of sub-pixel driving circuits.

Exemplarily, the plurality of reset signal lines RST correspond to the plurality of rows of sub-pixel driving circuits in a one-to-one manner, and the reset signal lines RST are respectively coupled to each sub-pixel driving circuit in the corresponding row of sub-pixel driving circuits.

Exemplarily, the plurality of power supply lines VDD correspond to the plurality of columns of sub-pixel driving circuits in a one-to-one manner, and the power supply lines VDD are respectively coupled to each sub-pixel driving circuit in the corresponding column of sub-pixel driving circuits.

Exemplarily, the plurality of data lines DA correspond to the plurality of columns of sub-pixel driving circuits on a one-to-one manner, and the data lines DA are respectively coupled to each sub-pixel driving circuit in the corresponding column of sub-pixel driving circuits.

As shown in FIG. 1, the sub-pixel driving circuit includes a first transistor T1, a second transistor T2, a third transistor T3, a fourth transistor T4, a fifth transistor T5, a sixth transistor T6, a seventh transistor T7 and a storage capacitor Cst. FIG. 1 also illustrates the N1 node, N2 node, N3 node and N4 node.

For example, each transistor included in the sub-pixel driving circuit may be a low-temperature polysilicon (LTPS) transistor, but it is not limited to this.

The gate electrode of the first transistor T1 is coupled to the corresponding reset signal line RST, and the first electrode of the first transistor T1 is coupled to the first initialization signal transmission layer Vinit1, the second electrode of the first transistor T1 is coupled to the gate electrode of the third transistor T3.

The gate electrode of the second transistor T2 is coupled to the corresponding second scanning line GA2, the first electrode of the second transistor T2 is coupled to the second electrode of the third transistor T3, and the second electrode of the second transistor T2 is coupled to the gate electrode of the third transistor T3.

The gate electrode of the fourth transistor T4 is coupled to the corresponding first scanning line GA1, the first electrode of the fourth transistor T4 is coupled to the corresponding data line DA, and the second electrode of the fourth transistor T4 is coupled to the first electrode of the third transistor T3.

The gate electrode of the fifth transistor T5 is coupled to the corresponding first light emitting control signal line EM1, and the first electrode of the fifth transistor T5 is coupled to the corresponding power line VDD, the second electrode of the fifth transistor T5 is coupled to the first electrode of the third transistor T3.

The gate electrode of the sixth transistor T6 is coupled to the corresponding second light emitting control signal line EM2, and the first electrode of the sixth transistor T6 is coupled to the second electrode of the third transistor T3, the second electrode of the sixth transistor T6 is coupled to the anode of the light emitting element.

The gate electrode of the seventh transistor T7 is coupled to the corresponding first scanning line GA1. The first electrode of the seventh transistor T7 is coupled to the second initialization signal transmission layer Vinit2. The second electrode of the seventh transistor T7 is coupled to the anode of the light emitting element. The cathode layer serves as the cathode of the light emitting element.

The first electrode plate Cst1 of the storage capacitor Cst is coupled to the gate electrode of the third transistor T3, and the second electrode plate Cst2 of the storage capacitor Cst is coupled to the corresponding power line VDD. Exemplarily, the gate electrode T3-g of the third transistor T3 is multiplexed as the first electrode plate Cst1.

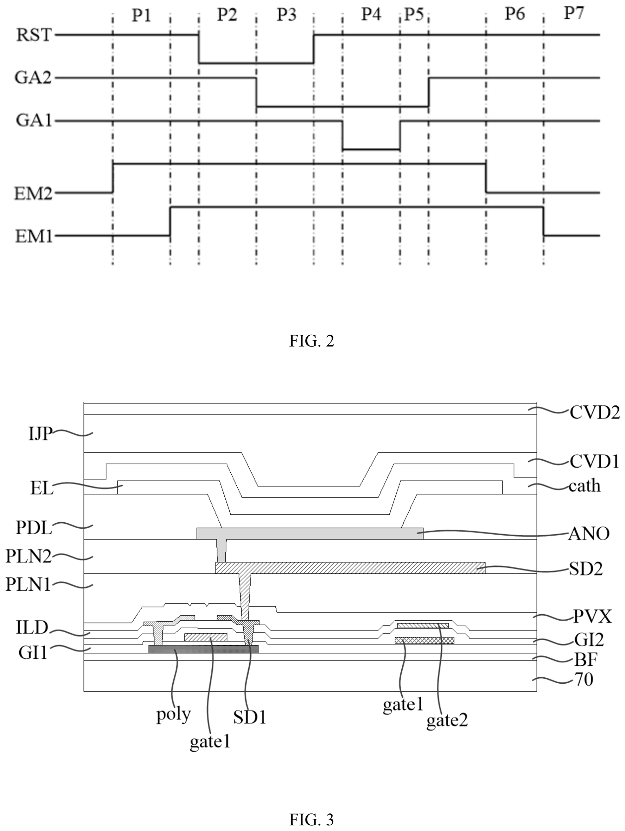

As shown in FIG. 2, the working process of the sub-pixel driving circuit is as follows:

In the P1 phase: the sixth transistor T6 is turned off, the fifth transistor T5 continues to be turned on, and the high-level power signal transmitted by the power line VDD performs a high-voltage bias on the third transistor T3, thereby improving the hysteresis of the third transistor T3 (i.e., the driving transistor).

In the P2 phase: the first transistor T1 is turned on, and the first initialization signal transmitted by the first initialization signal transmission layer Vinit1 initializes the gate electrode of the third transistor T3 (i.e., the N1 node).

In the P3 phase: the first transistor T1 continues to be turned on, the second transistor T2 is turned on, and the first initialization signal performs low-level initialization on the N1 node, N2 node and N3 node at the same time, so that before the data signal is written, the potential environment of the nodes N1 node, N2 node and N3 node related to the third transistor T3 remains consistent, which improves the frequency switching flicker problem.

In the P4 phase: the second transistor T2 continues to be turned on, the fourth transistor T4 is turned on, the data line DA writes data signals, and the third transistor T3 performs threshold voltage Vth compensation at the same time.

In the P5 phase: the fourth transistor T4 is turned off, the second transistor T2 continues to be turned on, and the third transistor T3 continues to compensate for the threshold voltage Vth.

In the P6 phase: the sixth transistor T6 is turned on and the fifth transistor T5 is turned off. Before the light emitting element emits light, the N2 node, N3 node and N4 node are connected, so that the N2 node, N3 node and N4 node are connected, and the voltage reaches the stability state before light emitting.

In the P7 phase: the fifth transistor T5 is turned on, the sixth transistor T6 continues to be turned on, and the light emitting element emits light.

Referring to FIGS. 1, 5, 9 and 10, embodiments of the present disclosure provide a display substrate, including: a base substrate, a power line VDD, a first light emitting control signal, the second light emitting control signal line EM2 and a plurality of sub-pixels all arranged on the base substrate; the sub-pixels include a sub-pixel driving circuit and a light emitting element, the sub-pixel driving circuit includes a driving transistor (i.e., the third transistor T3), a power control transistor (i.e., the fifth transistor T5) and a light emitting control transistor (i.e., the sixth transistor T6);

The gate electrode T5-g of the power control transistor is coupled to the corresponding first light emitting control signal line EM1, the first electrode of the power control transistor is coupled to the corresponding power line VDD, and the second electrode of the power control transistor is coupled to the first electrode of the driving transistor, the gate electrode T6-g of the light emitting control transistor is coupled to the corresponding second light emitting control signal line EM2, and the first electrode of the light emitting control transistor is connected to the second electrode of the driving transistor, and the second electrode of the light emitting control transistor is coupled to the light emitting element;

The first light emitting control signal line EM1 includes at least part extending along a first direction, the second light emitting control signal line EM2 includes at least part extending along the first direction, and the orthographic projection of the first light emitting control signal line EM1 on the base substrate and the orthographic projection of the second light emitting control signal line EM2 on the base substrate are arranged along a second direction, and the second direction intersects the first direction.

Exemplarily, the display substrate includes a plurality of first light emitting control signal lines EM1, the plurality of first light emitting control signal lines EM1 are arranged along the second direction, and the first light emitting control signal line EM1 includes at least part extending in the first direction.

Exemplarily, the display substrate includes a plurality of second light emitting control signal lines EM2, the plurality of second light emitting control signal lines EM2 are arranged along the second direction, and the second light emitting control signal line EM2 includes at least part extending in the first direction.

Exemplarily, the display substrate further includes a plurality of shift register units (also called GOA units), and the first light emitting control signal line EM1 and the second light emitting control signal coupled to the same row of sub-pixel driving circuits are driven by different GOA units respectively.

For example, the orthographic projection of the first light emitting control signal line EM1 on the base substrate does not overlap the orthographic projection of the second light emitting control signal line EM2 on the base substrate.

As shown in FIG. 3, for example, the display substrate includes a buffer layer BF, an active layer poly, a first gate insulating layer GI1, a first gate metal layer gate1, a second gate insulating layer GI2, a second gate metal layer gate2, an interlayer insulating layer ILD, a first source-drain metal layer SD1, a first planarization layer PLN1, a second source-drain metal layer SD2, a second planarization layer PLN2, an anode layer ANO, a light emitting functional layer EL, a cathode layer cath, a first inorganic encapsulation layer CVD1, an organic encapsulation layer IJP and a second inorganic encapsulation layer CVD2, etc laminated sequentially in a direction away from the base substrate 70. The display substrate may also include a passivation layer PVX, but is not limited thereto.

Exemplarily, the first light emitting control signal line EM1 and the gate electrode T5-g of the power control transistor are arranged in different layers; and/or the second light emitting control signal line EM2 and the gate electrode T6-g of the light emitting control transistor are arranged in different layers.

For example, the first light emitting control signal line EM1 and/or the second light emitting control signal line EM2 and the first source-drain metal layer are arranged in the same layer and made of the same material. The gate electrode T5-g of the power control transistor and the gate electrode T6-g of the light emitting control transistor are arranged in the same layer and made of a same material as the first gate metal layer. This arrangement method is beneficial to reducing the layout difficulty of the display substrate and improving the resolution of the display substrate.

According to the specific structure of the above display substrate, in the display substrate provided by the embodiment of the present disclosure, in the same sub-pixel driving circuit, the gate electrode T5-g of the power control transistor is coupled to the corresponding first light emitting control signal line EM1, the gate electrode T6-g of the light emitting control transistor is coupled to the corresponding second light emitting control signal line EM2, so that the power control transistor and the light emitting control transistor can realize independent control on the corresponding first light emitting control signal line EM1 and the second light emitting control signal line EM2, which can realize the independent control on the power control transistor to turn on in the initial phase (i.e., the above-mentioned P1 phase), so that the power signal transmitted by the power line VDD can be transmitted to the first electrode of the driving transistor through the power control transistor, so that the driving transistor to have a high voltage bias in the initial phase, effectively improving the hysteresis of the driving transistor; at the same time, in the initialization phase (i.e., the above-mentioned P3 phase), both the power control transistor and the light emitting control transistor are controlled to be cut off, to realize low level initialization on the gate electrode T3-g, the first electrode and the second electrode of the driving transistor at the same time, and so that before the writing of the data signal, the potential environment of the gate electrode T3-g, the first electrode and the second electrode of the driving transistor remains consistent, thereby effectively improving the flickering problem of frequency switching.

In the display substrate provided by the embodiment of the present disclosure, a plurality of sub-pixel driving circuits included in the plurality of sub-pixels are arranged in an array, and the plurality of sub-pixel driving circuits are divided into a plurality of rows of sub-pixel driving circuits. The plurality of rows of sub-pixel driving circuits are arranged along the second direction, each row of sub-pixel driving circuits includes a plurality of sub-pixel driving circuits arranged along the first direction. A plurality of first light emitting control signal lines EM1 are arranged along the second direction, and a plurality of second light emitting control signal lines EM2 are arranged along the second direction. The orthographic projection of the first light emitting control signal lines EM1 on the base substrate and the orthographic projection of the second light emitting control signal line EM2 on the base substrate are alternately arranged along the second direction, and the first light emitting control signal line EM1 includes at least part extending along the first direction, The second light emitting control signal line EM2 includes at least part extending along the first direction.

The above arrangement enables each power control transistor included in a row of sub-pixel driving circuits to be coupled to a corresponding first light emitting control signal line EM1, so that each power supply control transistor included in a row of sub-pixel driving circuits can be coupled to a corresponding second light emitting control signal line EM2. When the power control transistor and the light emitting control transistor can be controlled independently, the layout space of the display substrate is reasonably planned, which reduces the layout difficulty of the display substrate while ensuring high resolution.

In the display substrate provided by the embodiment of the present disclosure, the orthographic projection of the first light emitting control signal line EM1 on the base substrate does not overlap the orthographic projection of the second light emitting control signal line EM2 on the base substrate, which can avoid interference between the first light emitting control signal transmitted by the first lighting control signal line EM1 and the second light emitting control signal transmitted by the second lighting control signal line EM2, ensure to stably transmit the light emitting control signal.

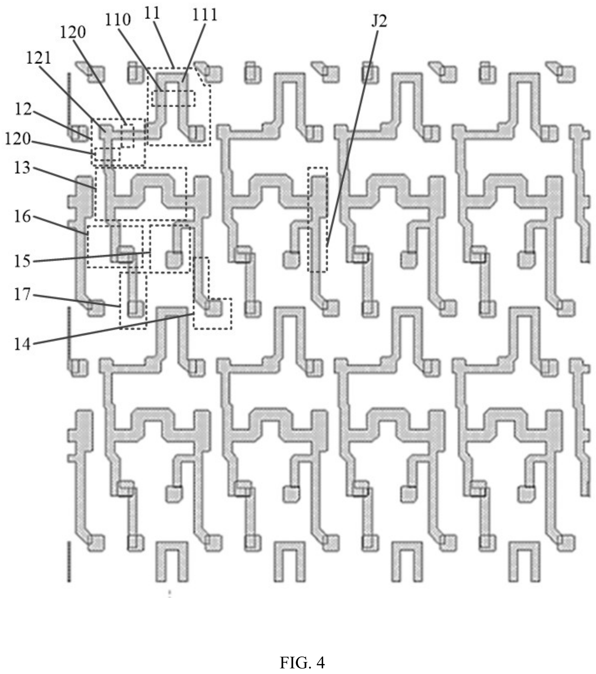

As shown in FIG. 4, in some embodiments, the power control transistor includes a power control active layer 15, the light emitting control transistor includes a light emitting control active layer 16, and the power control active layer 15 and the light emitting control active layer 16 are arranged along the first direction.

Exemplarily, the power control active layer 15 includes a power control channel portion, and the orthographic projection of the power control channel portion on the base substrate is covered by the orthographic projection of the gate electrode T5-g of the power control transistor on the base substrate. The light emitting control active layer 16 includes a light emitting control channel portion. An orthographic projection of the light emitting control channel portion on the base substrate is covered by the orthographic projection of the gate electrode T6-g of the light emitting control transistor on the base substrate.

Exemplarily, the gate electrode T5-g of the power control transistor includes at least part extending along the first direction. The gate electrode T6-g of the light emitting control transistor includes at least part extending along the first direction.

Exemplarily, at least part of the gate electrode T5-g of the power control transistor and at least part of the gate electrode T6-g of the light emitting control transistor are arranged along the first direction.

Exemplarily, at least part of the power control channel portion and at least part of the light emitting control channel portion are arranged along the first direction.

Exemplarily, in the layout area of the same sub-pixel driving circuit, at least part of the orthographic projection of the first light emitting control signal line EM1 on the base substrate is located between the orthographic projection of the gate electrode T3-g of the driving transistor on the base substrate and the orthographic projection of the second light emitting control signal line on the base substrate.

Exemplarily, at least part of the orthographic projection of the gate electrode T5-g of the power control transistor on the base substrate, and/or, at least part of the orthographic projection of the gate electrode T6-g of the light emitting control transistor on the base substrate is located between the orthographic projection of the first light emitting control signal line EM1 on the base substrate and the orthographic projection of the second light emitting control signal line on the base substrate.

The above arrangement method reasonably designs the layout space of the display substrate, which is conducive to improving the resolution of the display substrate and reducing the layout difficulty of the display substrate.

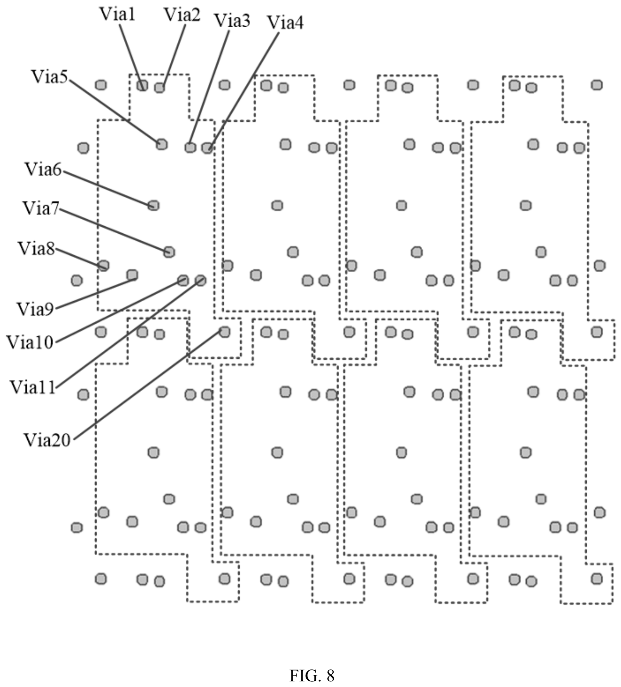

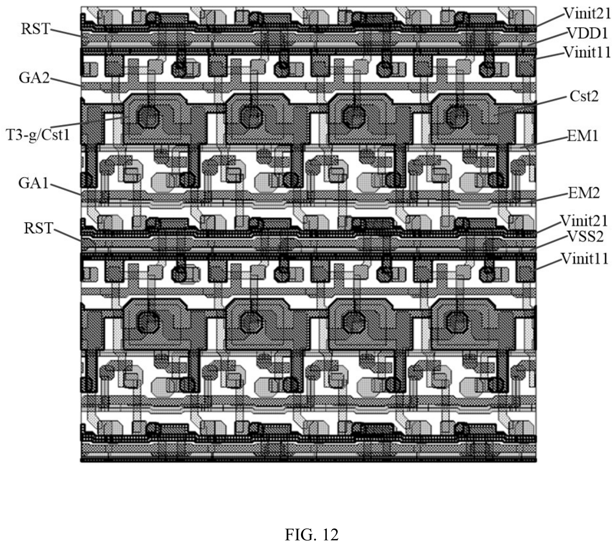

As shown in FIGS. 5 to 12, in some embodiments, the display substrate further includes a first scanning line GA1 and a data line DA; the sub-pixel driving circuit includes a data writing-in transistor (i.e., a fourth transistor T4), The gate electrode of the data writing-in transistor is coupled to the corresponding first scanning line GA1, the first electrode of the data writing-in transistor is coupled to the corresponding data line DA, and the second electrode of the data writing-in transistor is coupled to the first electrode of the driving transistor;

In the layout area of the same sub-pixel driving circuit, at least part of the orthographic projection of the first scanning line GA1 on the base substrate is located between the orthographic projection of the first light emitting control signal line EM1 on the base substrate and the orthographic projection of the second light emitting control signal line EM2 on the base substrate.

For example, the orthographic projection of the first scanning line GA1 on the base substrate partially overlaps the orthographic projection of the second light emitting control signal line EM2 on the base substrate.

Exemplarily, the second light emitting control signal line EM2 includes a second light emitting control body portion and a second light emitting control protruding portion that are coupled to each other, and the second light emitting control body portion includes at least part extending along the first direction, the second light emitting control protruding portion protrudes from the second light emitting control body portion along the second direction. The second light emitting control protruding portion is coupled to the gate electrode T6-g of the light emitting control transistor.

Exemplarily, the first light emitting control signal line EM1 includes a first light emitting control body portion and a first light emitting control protruding portion that are coupled to each other, and the first light emitting control body portion includes at least part extending along the first direction, the first light emitting control protruding portion protrudes from the first light emitting control body portion along the second direction. The first light emitting control protruding portion is coupled to the gate electrode T5-g of the power control transistor.

Exemplarily, the first light emitting control protruding portion and the second light emitting control protruding portion are located between the first light emitting control body portion and the second light emitting control body portion.

For example, the orthographic projection of the first scanning line GA1 on the base substrate does not overlap the orthographic projection of the first light emitting control signal line EM1 on the base substrate.

For example, the orthographic projection of the first scanning line GA1 on the base substrate does not overlap the orthographic projection of the second light emitting control body portion on the base substrate.

For example, the orthographic projection of the first scanning line GA1 on the base substrate partially overlaps the orthographic projection of the second light emitting control protruding portion on the base substrate.

Exemplarily, the orthographic projection of the first scanning line GA1 on the base substrate does not overlap the orthographic projection of the first light emitting control signal line EM1 on the base substrate; and/or, the orthographic projection of the first scanning line GA1 on the base substrate does not overlap the orthographic projection of the second light emitting control signal line EM2 on the base substrate.

The above arrangement enables the orthographic projection of the first scanning line GA1 on the substrate to avoid as much as possible to overlap the orthographic projection of the first light emitting control signal line EM1 on the substrate and the orthographic projections of the second light emitting control signal line EM2 on the base substrate, and the overlapping area between the first scanning line GA1 and the first light emitting control signal line EM1 and the second light emitting control signal line EM2 is minimized, which can not only reduce the loading of the first scanning line GA1, but also avoid poor display due to crosstalk between signals, and avoid poor display split caused by multiple pulses of the first light emitting control signal and the second light emitting control signal.

As shown in FIG. 4, in some embodiments, the data writing-in transistor includes a data writing-in active layer 14, the power control transistor includes a power control active layer 15, and the driving transistor includes a driving active layer 13; a first end of the data writing-in active layer 14 (used as the second electrode of the data writing-in transistor, and the second electrode can be selected as the drain electrode), the first end of the power control active layer 15 (used as the second electrode of the power control transistor, and the second electrode can be the drain electrode) and the first terminal of the driving active layer 13 (used as the first electrode of the driving transistor) are coupled to each other to form a second node portion J2 (that is, corresponding to the second node N2);

At least part of the data writing-in active layer 14 and at least part of the power control active layer 15 are located on the same side of the driving active layer 13 in the second direction.

Exemplarily, the data writing-in active layer 14 includes at least part extending along the second direction, and the data writing-in active layer 14 is located at a side of the second node portion J2 away from the driving active layer 13. Exemplarily, the channel portion included in the data writing-in active layer 14 is located on a side of the second node portion J2 away from the driving active layer 13, and the orthographic projection of the channel portion on the base substrate overlaps the orthographic projection of the first scanning line GA1 on the base substrate.

Exemplarily, the orthographic projection of the data writing-in active layer 14 on the base substrate at least partially overlaps the orthographic projection of the second light emitting control signal line EM2 on the base substrate. This arrangement is conducive to reducing the layout space occupied by the second light emitting control signal line EM2 and is conducive to improving the resolution of the display substrate.

Exemplarily, the sub-pixel driving circuit further includes a storage capacitor Cst. The first electrode plate Cst1 of the storage capacitor Cst is coupled to the gate electrode T3-g of the driving transistor. The second electrode plate Cst2 of the storage capacitor Cst is coupled to the power line VDD;

As shown in FIGS. 5 to 7, the second electrode plate Cst2 includes an electrode plate main portion Cst21 and an electrode plate extension portion Cst22 coupled to each other. The orthographic projection of the electrode plate main portion Cst21 on the base substrate partially overlaps the orthographic projection of the first electrode plate Cst1 on the base substrate, the orthographic projection of the electrode plate extension portion Cst22 on the base substrate does not overlap the orthographic projection of the first electrode plate Cst1 on the base substrate. The orthographic projection of the electrode plate extension portion Cst22 on the base substrate at least partially overlaps the orthographic projection of the second node portion J2 on the base substrate.

Exemplarily, the electrode plate main portion Cst21 and the electrode plate extension portion Cst22 are formed into an integrated structure.

Exemplarily, the electrode plate main portions Cst21 located in the same row along the first direction are coupled in sequence to form an electrode plate structure extending along the first direction. This electrode plate structure is connected to a power signal and can form a grid structure with the power supply line VDD.

The above arrangement enables the second electrode of the data writing-in transistor, and the second electrode of the power control transistor to be directly coupled to the first electrode of the driving transistor through the active layer, without other film layers for connection, which can effectively reduce the number of via holes and optimize the wiring space.

Moreover, the above arrangement makes the active layer lines corresponding to the second node portion J2 longer. In this way, by arranging the orthographic projection of the electrode plate extension portion Cst22 on the base substrate to overlap the orthographic projection of the second node portion J2 on the base substrate, which can optimize the capacitance value between the N2 node and the second electrode plate Cst2 of the storage capacitor Cst, so that the N2 node can be fully shielded by a stable power signal, and it is beneficial to improve the grayscale Mura and afterimage performance of low display substrates.

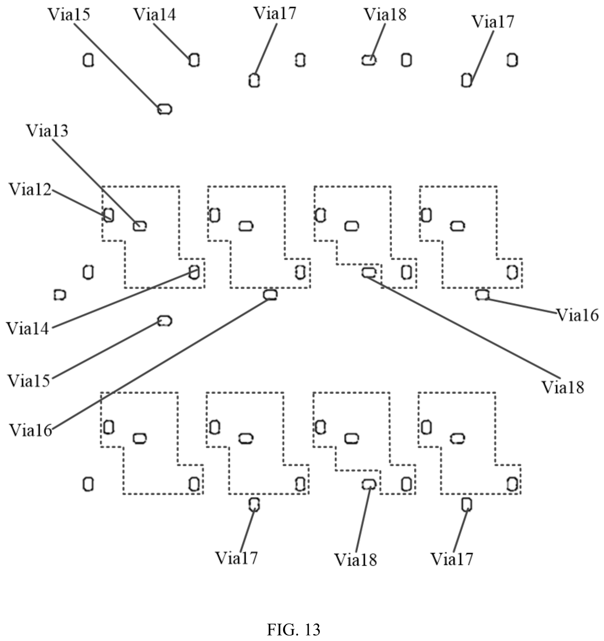

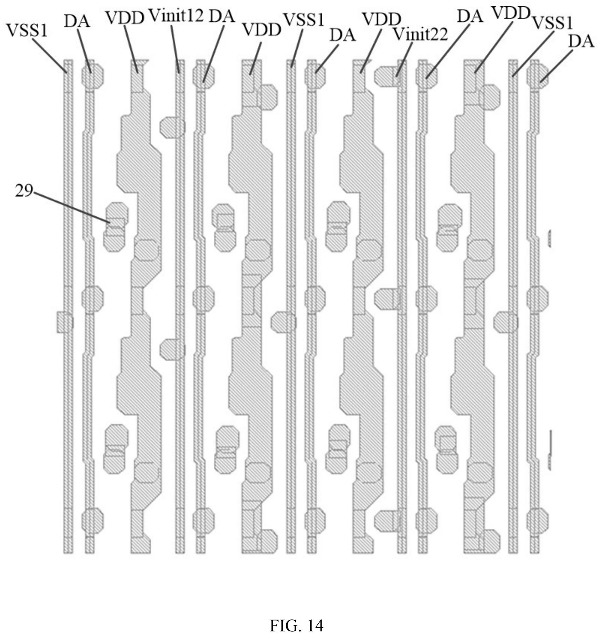

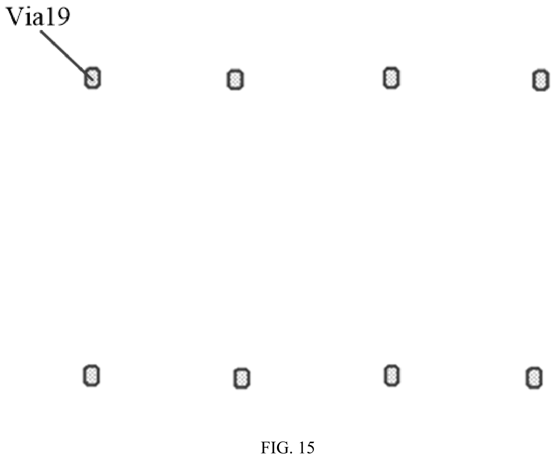

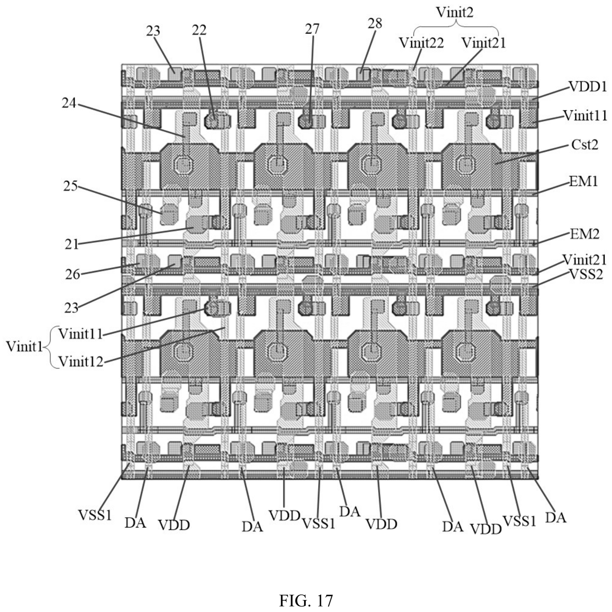

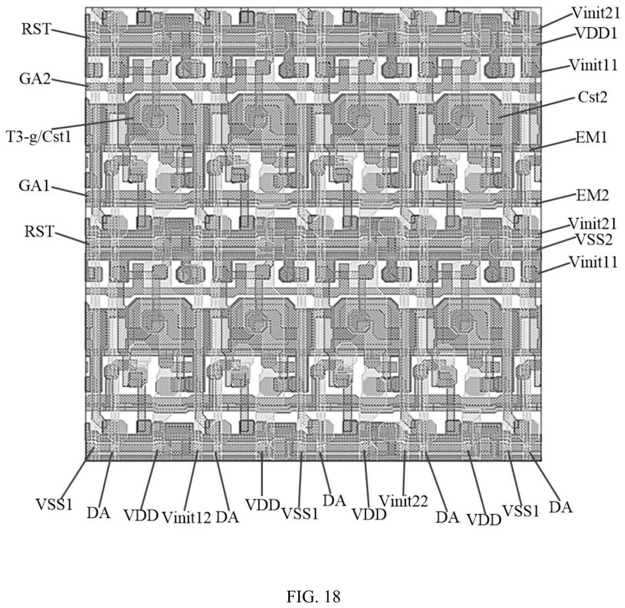

As shown in FIGS. 1 to 18, in some embodiments, the sub-pixel driving circuit further includes a first conductive connection portion 21, and the first conductive connection portion 21 is respectively connected to the first electrode of the power control transistor, the electrode plate extension portion Cst22 and the power line VDD; the orthographic projection of the first conductive connection portion 21 on the base substrate does not overlap the orthographic projection of the electrode plate main portion Cst21 on the base substrate.

Exemplarily, the first conductive connection portion 21 includes at least part extending along the first direction.

The above arrangement enables electrical connection among the first electrode of the power control transistor, the electrode plate extension portion Cst22 and the power line VDD through only one first conductive connection portion 21, which is conducive to simplifying the circuit structure, improving the resolution of the display substrate.

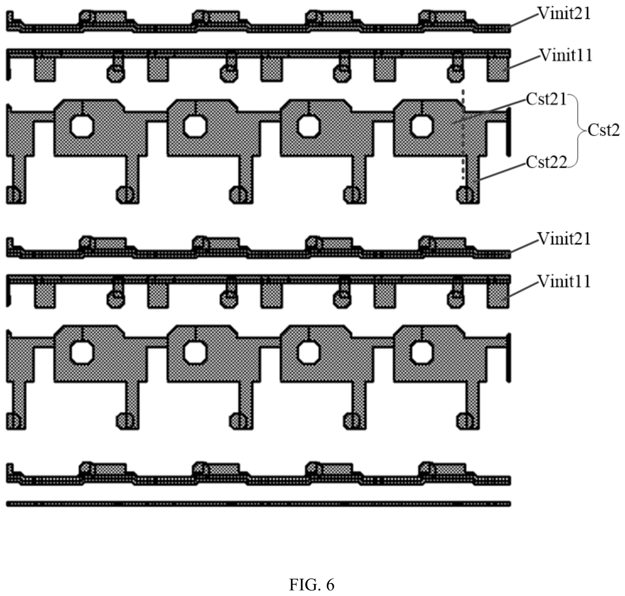

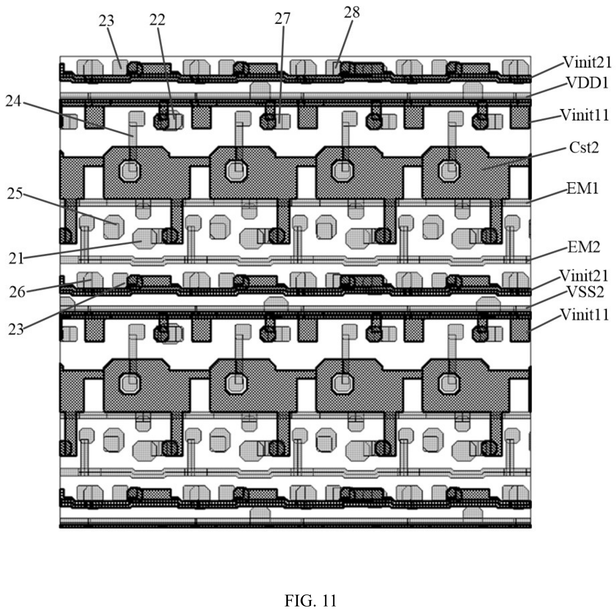

As shown in FIGS. 6 and 11, in some embodiments, the orthographic projection of the electrode plate extension portion Cst22 on the base substrate partially overlaps the orthographic projection of the first light emitting control signal line EM1 on the base substrate, and does not overlap the orthographic projection of the second light emitting control signal line EM2 on the base substrate.

The above arrangement enables the second light emitting control signal line EM2 to avoid overlapping the structure for transmitting power signals as much as possible.

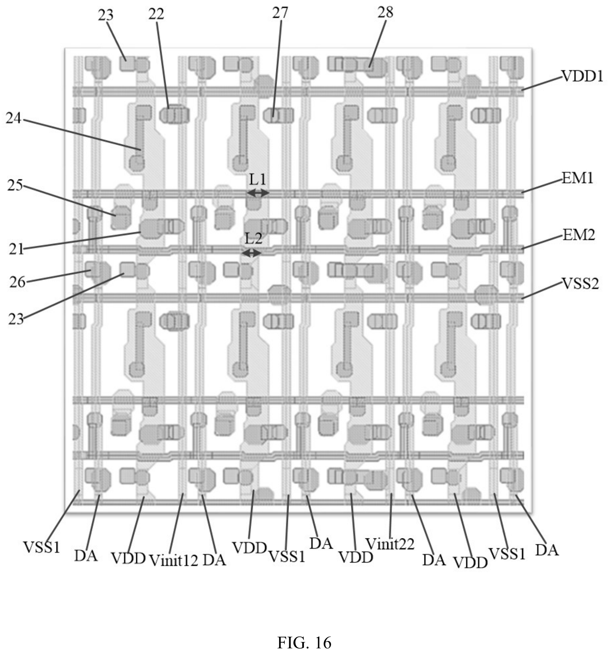

As shown in FIG. 16, in some embodiments, the power line VDD includes at least part extending along the second direction; there is a first overlapping area between the orthographic projection of the power line VDD on the base substrate and the orthographic projection of the first light emitting control signal line EM1 on the base substrate, and there is a second overlapping area between the orthographic projection of the power line VDD on the base substrate and the orthographic projection of the second light emitting control signal line EM2 on the base substrate; the length L1 of the first overlapping area along the first direction is greater than the length L2 of the second overlapping area along the first direction.

Exemplarily, the length of the second overlapping region along the first direction may be between 2 microns and 5 microns, and may include endpoint values, but is not limited thereto.

Exemplarily, there is a third overlapping area between the orthographic projection of the power line VDD on the base substrate and the orthographic projection of the second scanning line GA2 on the base substrate, and the length of the third overlapping area along the first direction is greater than the length of the second overlapping area along the first direction.

The above arrangement allows the power line VDD to be narrowed in the second overlapping area, so that the second light emitting control signal line EM2 can minimize the overlapping area with the structure that transmits the power signal.

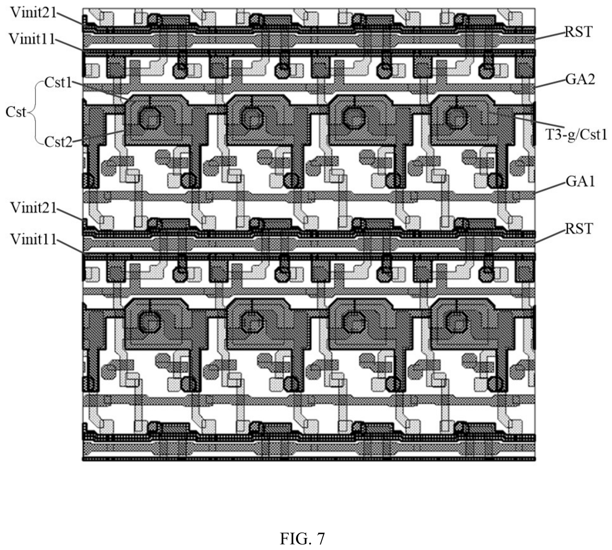

As shown in FIGS. 7, 9, 11, 12, 14 and 17, in some embodiments, the display substrate further includes a first initialization signal transmission layer Vinit1. The first initialization signal transmission layer Vinit1 includes a plurality of first initialization transmission portions Vinit11 and a plurality of second initialization transmission portions Vinit12, the extension direction of the first initialization transmission portions Vinit11 intersects the extension direction of the second initialization transmission portion Vinit12;

At least part of the sub-pixel driving circuit also includes a first reset transistor (i.e., the first transistor T1) and a second conductive connection portion 22. The second conductive connection portion 22 is respectively connected to the first electrode of the first reset transistor, the corresponding first initialization transmission portion Vinit11 and the corresponding second initialization transmission portion Vinit12; the second electrode of the first reset transistor is coupled to the gate electrode T3-g of the driving transistor.

For example, the first initialization signal transmission layer Vinit1 is configured to transmit the first initialization signal. The first initialization signal transmission layer Vinit1 is formed into a grid-like structure.

Exemplarily, the plurality of first initialization transmission portions Vinit11 are arranged in sequence along the second direction. The first initialization transmission portion Vinit11 includes at least part extending along the first direction. The first initialization transmission portion Vinit11 Vinit11 and the second gate metal layer are arranged at the same layer and made of the same material.

Exemplarily, the plurality of second initialization transmission portions Vinit12 are arranged in sequence along the first direction, and the second initialization transmission portion Vinit12 includes at least part extending along the second direction. The second initialization transmission portion Vinit12 Vinit12 and the second source-drain metal layer are arranged at the same layer and made of the same material.

Exemplarily, the gate electrode of the first reset transistor is coupled to the corresponding reset signal line RST.

The above setting method is beneficial to reducing the resistance of the first initialization signal transmission layer Vinit1, reducing the loading of the first initialization signal transmission layer Vinit1, and improving the uniformity of the first initialization signal transmitted by the first initialization signal transmission layer Vinit1.

As shown in FIGS. 7, 9, 11, 12, 14 and 17, in some embodiments, the display substrate further includes a second initialization signal transmission layer Vinit2. The second initialization signal transmission layer Vinit2 includes a plurality of third initialization transmission portions Vinit21 and a plurality of fourth initialization transmission portions Vinit22, the extension direction of the third initialization transmission portion Vinit21 intersects the extension direction of the fourth initialization transmission portion Vinit22;

At least part of the sub-pixel driving circuit also includes a second reset transistor (i.e., a seventh transistor T7) and an eighth conductive connection portion. The eighth conductive connection portion is respectively connected to the first electrode of the second reset transistor, the corresponding third initialization transmission portion Vinit21 and the corresponding fourth initialization transmission portion Vinit22; the second electrode of the second reset transistor is coupled to the light emitting element.

For example, the second initialization signal transmission layer Vinit2 is configured to transmit the second initialization signal. The second initialization signal transmission layer Vinit2 is formed into a grid-like structure.

Exemplarily, the plurality of third initialization transmission portions Vinit21 are arranged in sequence along the second direction, and the third initialization transmission portion Vinit21 includes at least part extending along the first direction. The third initialization transmission portion Vinit21 and the second gate metal layer are arranged at the same layer and made of the same material.

Exemplarily, the plurality of fourth initialization transmission portions Vinit22 are arranged in sequence along the first direction, and the fourth initialization transmission portion Vinit22 includes at least part extending along the second direction. The fourth initialization transmission portion Vinit22 and the second source-drain metal layer are arranged at the same layer and made of the same material.

Exemplarily, the gate electrode of the second reset transistor is coupled to the corresponding first scanning line GA1. The second reset transistor T7 and the data writing-in transistor T4 belonging to the same sub-pixel driving circuit share the same first scanning line GA1. This arrangement method is beneficial to reducing the complexity of the display substrate and improving the resolution of the display substrate.

The above setting method is beneficial to reducing the resistance of the second initialization signal transmission layer Vinit2, reducing the loading of the second initialization signal transmission layer Vinit2, and improving the uniformity of the second initialization signal transmitted by the second initialization signal transmission layer Vinit2.

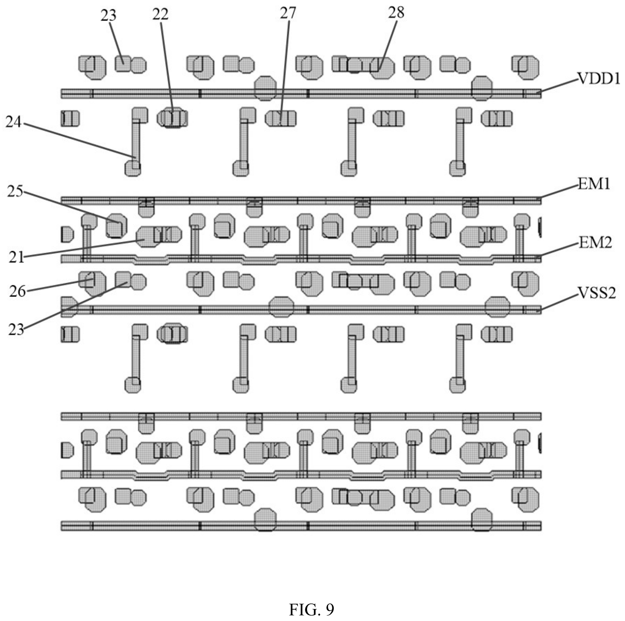

As shown in FIGS. 9, 11 to 18, in some embodiments, the display substrate further includes a cathode layer and a plurality of first cathode compensation lines VSS 1, the first cathode compensation lines VSS1 include at least part extending along the second direction, the plurality of the first cathode compensation lines VSS1 are respectively coupled to the cathode layer.

Exemplarily, the plurality of first cathode compensation lines VSS1 are arranged along the first direction, the first cathode compensation lines VSS1 include at least part extending along the second direction, and the first cathode compensation lines VSS1 and the second source-drain metal layer are arranged at the same layer and made of the same material.

Exemplarily, the display substrate includes a display area and a peripheral area located around the display area. The cathode layer can extend from the display area to the peripheral area. In the peripheral area, the first cathode compensation line VSS1 is coupled to the cathode layer through a transfer pattern, and the transfer pattern and the anode layer in the display substrate are arranged at the same layer and made of the same material, but is not limited thereto.

The above arrangement is beneficial to reducing the resistance of the cathode layer, reducing the loading of the cathode layer, and improving the uniformity of the cathode signal.

As shown in FIGS. 7 to 18, in some embodiments, the first initialization transmission portion Vinit11 and the third initialization transmission portion Vinit21 are alternately arranged along the second direction; and/or the second initialization transmission portions Vinit12 and the fourth initialization transmission portions Vinit22 are alternately arranged along the first direction; and/or, at least part of the first cathode compensation line VSS1 is located between the adjacent second initialization transmission portion Vinit12 and the fourth initialization transmission portion Vinit22.

Exemplarily, the second initialization transmission portion Vinit12, the first cathode compensation line VSS 1, the fourth initialization transmission portion Vinit22 and the first cathode compensation line VSS1 are cyclically arranged in sequence along the first direction.

For example, the second initialization transmission portion Vinit12, the first cathode compensation line VSS 1, and the fourth initialization transmission portion Vinit22 are all arranged in the same layer and made of the same material as the second source-drain metal layer.

For example, each column of sub-pixel driving circuits only corresponds to one of the second initialization transmission portion Vinit12, the first cathode compensation line VSS1, and the fourth initialization transmission portion Vinit22, but it is not limited thereto.

In more detail, among the four adjacent columns of sub-pixel driving circuits, the second initialization transmission portion Vinit12 is laid out in the layout area of the first column of sub-pixel driving circuits, and the first cathode compensation line VSS1 is laid out in the layout area of the second column of sub-pixel driving circuits, the fourth initialization transmission portion Vinit22 is laid out in the layout area of the third column of sub-pixel driving circuits, and the first cathode compensation line VSS1 is laid out in the layout area of the fourth column of sub-pixel driving circuits. In the above case, the sub-pixel driving circuits in the first column of sub-pixel driving circuits include the second conductive connection portion 22. The sub-pixel driving circuit in the third column of sub-pixel driving circuits includes the eighth conductive connection portion.

It is worth noting that the wiring density of the second initialization transmission portion Vinit12, the first cathode compensation line VSS1 and the fourth initialization transmission portion Vinit22 can be flexibly adjusted.

As shown in FIG. 16, in some embodiments, the display substrate includes a plurality of power lines VDD and a plurality of data lines DA;

The second initialization transmission portion Vinit12 is located between the adjacent power line VDD and the data line DA; and/or the fourth initialization transmission portion Vinit22 is located between the adjacent power line VDD and the data line DA; and/or, the first cathode compensation line VSS1 is located between the adjacent power supply line VDD and the data line DA;

The adjacent power line VDD and the data line DA are coupled to the same sub-pixel driving circuit.

Exemplarily, the plurality of power lines VDD are arranged along the first direction, and the plurality of data lines DA are arranged along the first direction. Both the power lines VDD and the data lines DA are arranged in the same layer and made of the same material as the second source-drain metal layer. The power line VDD and the data line DA are alternately arranged along the first direction.

For example, in the layout area of a column of sub-pixel driving circuits, the second initialization transmission portion Vinit12 is located between the power line VDD and the data line DA; or the fourth initialization transmission portion Vinit22 is located between the power line VDD and the data line DA; or, the first cathode compensation line VSS1 is located between the power line VDD and the data line DA.

The above arrangement enables the second initialization transmission portion Vinit12, the fourth initialization transmission portion Vinit22 or the first cathode compensation line VSS1 to be provided between the data line DA and the power line VDD coupled to the same sub-pixel driving circuit, so that the data line DA and the power line VDD coupled to the same sub-pixel driving circuit can be separated by the second initialization transmission portion Vinit12, the fourth initialization transmission portion Vinit22 or the first cathode compensation line VSS1, to reduce crosstalk risk between the data line DA and the power line VDD.

As shown in FIG. 16, in some embodiments, the display substrate further includes a plurality of second cathode compensation lines VSS2 arranged along the second direction, and the second cathode compensation lines VSS2 include at least part extending along the first direction, the second cathode compensation line VSS2 is coupled to the first cathode compensation line VSS1.

Exemplarily, the second cathode compensation line VSS2 and the first source-drain metal layer are arranged in the same layer and made of the same material.

The above arrangement enables the first cathode compensation line VSS1 and the second cathode compensation line VSS2 to be formed into a grid-like structure, further reducing the loading of the cathode layer, improving the uniformity of the cathode signal, and effectively improving the heating problem of the display substrate under high-brightness display.

As shown in FIG. 16, in some embodiments, the display substrate further includes a plurality of power supply compensation lines VDD1. The power supply compensation lines VDD1 include at least part extending along the first direction. The power supply compensation lines VDD1 and the power line VDD is coupled; the power compensation line VDD1 and the second cathode compensation line VSS2 are alternately arranged along the second direction.

Exemplarily, the plurality of power compensation lines VDD1 are arranged along the second direction. The power compensation line VDD1 and the first source-drain metal layer are arranged in the same layer and made of the same material.

Exemplarily, one of the power supply compensation line VDD1 and the second cathode compensation line VSS2 is laid out in the layout area of the odd-numbered row of sub-pixel driving circuits, and the other one of the second cathode compensation line VSS2 and the power supply compensation line VDD1 is laid out in the layout area of the even-numbered row sub-pixel driving circuit.

The above-mentioned arrangement of the power supply compensation line VDD1 and the power supply line VDD allows the power supply compensation line VDD1 and the power supply line VDD to jointly form a grid structure, which is beneficial to reducing the loading of the power supply line VDD and improving the uniformity of the power signal and effectively improves the heating problem of the display substrate under high-brightness display.

Moreover, the second electrode plate Cst2 of the storage capacitor Cst in the display substrate is coupled to the power line VDD, receives the power signal, and the second electrode plates Cst2 located in the same row along the first direction are coupled in sequence, so the connection method of the second electrode plate Cst2, the power compensation line VDD1 and the power line VDD further reduces the loading of the power line VDD and improves the uniformity of the power signal.

The above arrangement that the power supply compensation line VDD1 and the second cathode compensation line VSS2 is alternately arranged along the second direction, which rationally utilizes the layout space of the display substrate and reduces the layout difficulty of the display substrate.

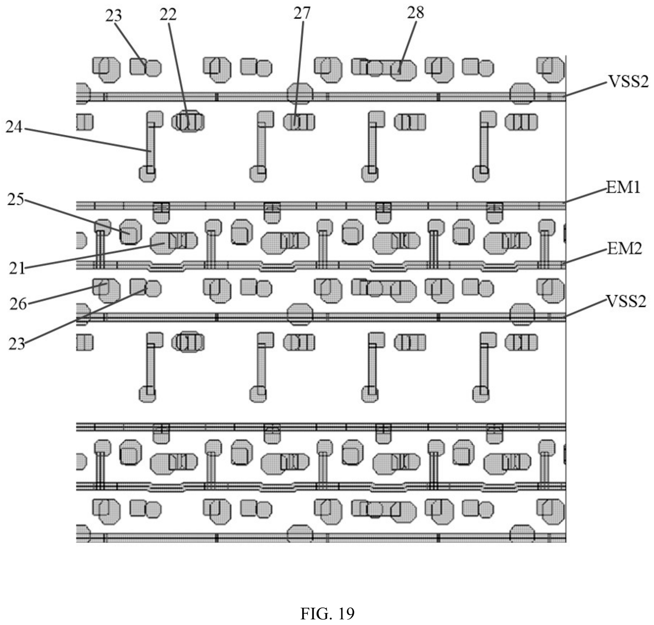

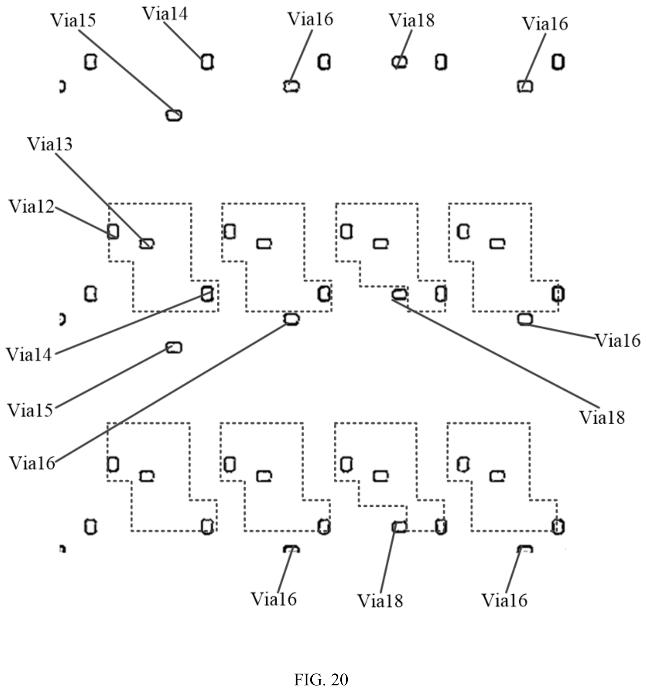

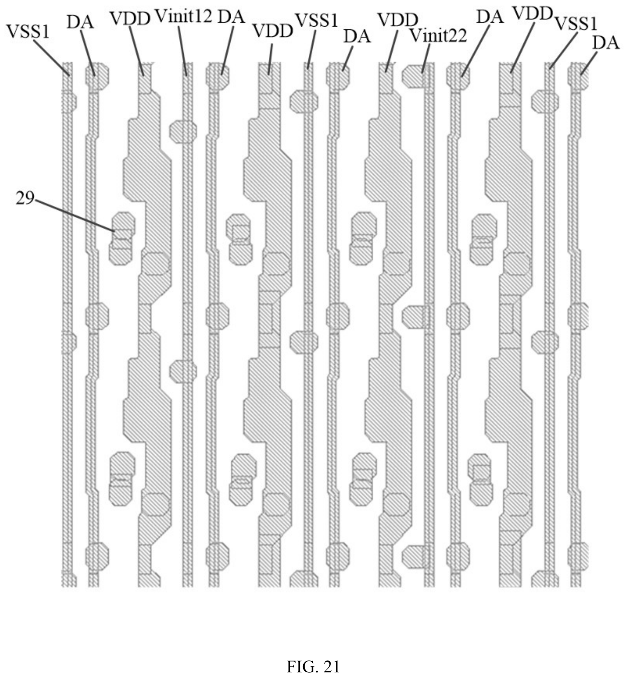

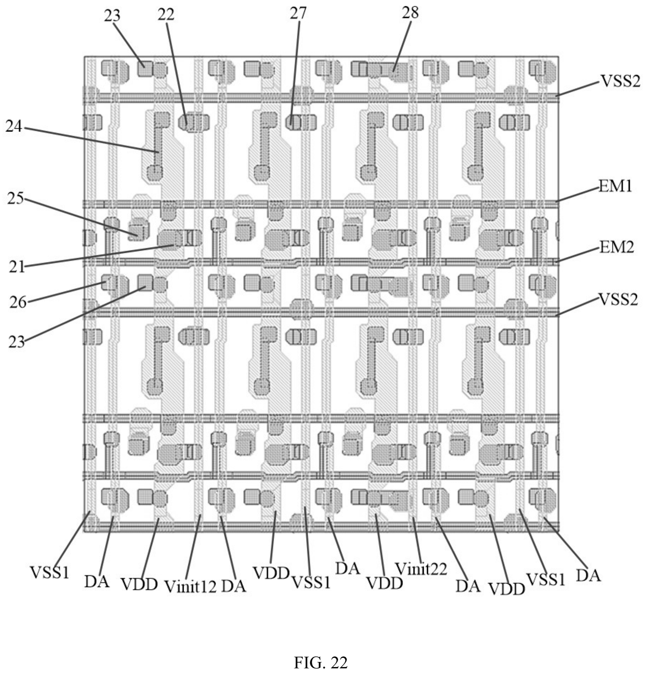

As shown in FIGS. 19 to 22, in some embodiments, the display substrate only includes the second cathode compensation line VSS2 and does not include the power supply compensation line VDD1. Each row of sub-pixel driving circuits corresponds to one second cathode compensation line VSS2. The second cathode compensation line VSS2 is located in the layout area of a corresponding row of sub-pixel driving circuits.

The above setting method can effectively reduce the electrode of the cathode layer and improve the drop of the cathode layer. It can effectively reduce the display power consumption of the display substrate displaying G255 gray scale under normal display. It can also reduce the power consumption of the display panel under high-brightness HBM display state.

As shown in FIGS. 4 to 7, in some embodiments, the first reset transistor (i.e., the first transistor T1 ) includes a first reset active layer 11, and the first reset active layer 11 includes two third channel portions 110, and a first conductive portion 111 respectively coupled to the two first channel portions 110; the orthographic projection of the first conductive portion 111 on the base substrate at least partially overlaps the orthographic projection of the third initialization transmission portion Vinit21 on the base substrate.

Exemplarily, the first reset transistor includes a dual-gate transistor.

Illustratively, the two first channel portions 110 and the first conductive portion 111 are jointly formed into a similar n-type structure, but are not limited thereto.

Exemplarily, the orthographic projection of the first conductive portion 111 on the base substrate at least partially overlaps the orthographic projection of the third initialization transmission portion Vinit21 on the base substrate. The third initialization transmission portion Vinit21 is located in the layout area of the sub-pixel driving circuit adjacent to the sub-pixel driving circuit to which the first conductive portion 111 belongs along the second direction.

The above arrangement enables the first conductive portion 111 included in the first reset transistor to be covered by the third initialization transmission portion Vinit21, so that the third initialization transmission portion Vinit21 can have a shielding effect on the first conductive portion 111, ensuring the stability of the first conductive portion 111, thereby ensuring the working stability of the first reset transistor.

As shown in FIGS. 4 to 7, in some embodiments, the sub-pixel driving circuit further includes a compensation transistor (i.e., a second transistor T2), and the first electrode of the compensation transistor is connected to the second electrode of the driving transistor, the second electrode of the compensation transistor is coupled with the gate electrode T3-g of the driving transistor;

The compensation transistor includes a compensation active layer 12, the compensation active layer 12 includes two second channel portions 120, and a second conductive portion 121 respectively coupled to the two second channel portions 120; The orthographic projection of the second conductive portion 121 on the base substrate at least partially overlaps the orthographic projection of the first initialization transmission portion Vinit11 on the base substrate.

Exemplarily, the compensation transistor includes a dual-gate transistor.

Exemplarily, the gate electrode of the compensation transistor is coupled to the corresponding second scanning line GA2. The compensation transistor can be independently controlled by the second scanning line GA2, which is conducive to fully compensating the threshold voltage of the driving transistor and improving the low-grayscale display quality of the display substrate.

Illustratively, the two second channel portions 120 and the second conductive portion 121 are jointly formed into a similar L-shaped structure, but are not limited thereto.

Exemplarily, the orthographic projection of the second conductive portion 121 on the base substrate at least partially overlaps the orthographic projection of the first initialization transmission portion Vinit11 on the base substrate. The first initialization portion is coupled to the sub-pixel driving circuit to which the second conductive part 121 belongs.

The above arrangement enables the second conductive portion 121 included in the compensation transistor to be covered by the first initialization transmission portion Vinit11, so that the first initialization transmission portion Vinit11 can have a shielding effect on the second conductive portion 121, ensuring the stability of the second conductive part 121 and ensuring the working stability of the compensation transistor.

As shown in FIG. 16, in some embodiments, the sub-pixel driving circuit further includes a fourth conductive connection portion 24, which is respectively coupled to the gate electrode T3-g of the driving transistor, the second electrode of the compensation transistor, and the second electrode of the first reset transistor. An orthographic projection of the fourth conductive connection portion on the base substrate at least partially overlaps an orthographic projection of the power line VDD on the base substrate. This arrangement can effectively shield the potential of the fourth conductive connection portion (corresponding to the potential of the N1 node) from interference.

Exemplarily, the orthographic projection of the fourth conductive connection portion on the base substrate is completely covered by the orthographic projection of the power line VDD on the base substrate.

Exemplarily, the orthographic projection of the second initialization transmission portion Vinit12 on the base substrate is located between the orthographic projection of the fourth conductive connection portion on the base substrate and the orthographic projection of the data line DA on the base substrate.

Exemplarily, the orthographic projection of the fourth initialization transmission portion Vinit22 on the base substrate is located between the orthographic projection of the fourth conductive connection portion on the base substrate and the orthographic projection of the data line DA on the base substrate.

Exemplarily, the orthographic projection of the first cathode compensation line VSS1 on the base substrate is located between the orthographic projection of the fourth conductive connection portion on the base substrate and the orthographic projection of the data line DA on the base substrate.

In more detail, as shown in FIG. 4, the first reset transistor includes the first reset active layer 11. The compensation transistor includes a compensation active layer 12. The driving transistor includes a driving active layer 13. The data writing-in transistor includes a data writing-in active layer 14. The power control transistor includes a power control active layer 15. The light emitting control transistor includes a light emitting control active layer 16. The second reset transistor includes a second reset active layer 17.

As shown in FIG. 9, the first to eighth conductive connection portions 21 to 28 are illustrated.

As shown in FIGS. 4 to 18, the first conductive connection portion 21 is coupled to the first electrode of the power control transistor through the tenth via hole Via10, and the first conductive connection portion is coupled to the electrode plate extension portion Cst22 through the eleventh via hole Via11, and the first conductive connection portion 21 is coupled to the power line VDD through the thirteenth via hole Via13.

The second conductive connection portion 22 is coupled to the first electrode of the first reset transistor through the fourth via hole Via4, and the second conductive connection portion 22 is coupled to the corresponding first initialization transmission portion Vinit11 through the third via hole Via3, and the second conductive connection portion 22 is coupled to the corresponding second initialization transmission portion Vinit12 through the fifteenth via hole Via15.

The third conductive connection portion 23 is coupled to the first electrode of the second reset transistor through the first via hole Via1. The third conductive connection portion 23 is coupled to the corresponding third initialization transmission portion Vinit21 through the second via hole Via2.

The fourth conductive connection portion 24 is coupled to the gate electrode T3-g of the driving transistor through a sixth via hole Via6, and the fourth conductive connection portion 24 is coupled to the second electrode of the compensation transistor and the second electrode of the first reset transistor through a fifth via hole Via5.

The fifth conductive connection portion 25 is coupled to the second electrode of the light emitting control transistor through the ninth via hole Via9. The fifth conductive connection portion 25 is coupled to the ninth conductive connection portion 29 through the twelfth via hole Via12. The ninth conductive connection portion 29 is coupled to the anode included in the light emitting element through the nineteenth via hole Via19.

The sixth conductive connection portion 26 is coupled to the first electrode of the data writing-in transistor through the twentieth via hole Via20. The sixth conductive connection portion is coupled to the data line DA through a fourteenth via hole Via14.

The seventh conductive connection portion 27 is coupled to the first electrode of the first reset transistor through the fourth via hole Via4, and the seventh conductive connection portion 27 is coupled to the corresponding first initialization transmission portion Vinit11 through the third via hole Via3.

The eighth conductive connection portion 28 is coupled to the first electrode of the second reset transistor through the first via hole Via1. The eighth conductive connection portion 28 is coupled to the corresponding third initialization transmission portion Vinit21 through the second via hole Via2. The eighth conductive connection portion 28 is coupled to the corresponding fourth initialization transmission portion Vinit22 through the eighteenth via hole Via18.

The first light emitting control signal line EM1 is coupled to the gate electrode of the power control transistor through the seventh via hole Via7. The second light emitting control signal line EM2 is coupled to the gate electrode of the light emitting control transistor through the eighth via hole Via8.

The first cathode compensation line VSS1 is coupled to the second cathode compensation line VSS2 through the sixteenth via hole Via16.

The power line VDD is coupled to the power compensation line VDD1 through the seventeenth via hole Via17.

An embodiment of the present disclosure also provides a display device, including the display substrate provided in the above embodiment.

It should be noted that the display device can be any product or component with a display function such as a television, a monitor, a digital photo frame, a mobile phone, a tablet computer, etc. The display device also includes a flexible circuit board, a printed circuit board and a back panel etc.

In the display substrate provided by the above embodiments, the plurality of sub-pixel driving circuits included in the plurality of sub-pixels are arranged in an array, and the plurality of sub-pixel driving circuits are divided into a plurality of rows of sub-pixel driving circuits. The plurality of rows of sub-pixel driving circuits are arranged along the second direction, each row of sub-pixel driving circuits includes a plurality of sub-pixel driving circuits arranged along the first direction. A plurality of first light emitting control signal lines are arranged along the second direction, a plurality of second light emitting control signal lines are arranged along the second direction, and the orthographic projection of the first light emitting control signal line on the base substrate and the orthographic projection of the second light emitting control signal line on the base substrate are alternately arranged along the second direction, the first light emitting control signal line includes at least part extending along the first direction, the second light emitting control signal line includes at least a part extending along the first direction.

The above arrangement enables each power control transistor included in a row of sub-pixel driving circuits to be coupled to a corresponding first light emitting control signal line, so that each power supply control transistor included in a row of sub-pixel driving circuits can be coupled to a corresponding second light emitting control signal line. While the power control transistor and the light emitting control transistor can be controlled independently, the layout space of the display substrate is reasonably planned, which reduces the layout difficulty of the display substrate while ensuring high resolution.

In the display substrate provided in the above embodiments, by setting that the orthographic projection of the first light emitting control signal line on the base substrate does not overlap the orthographic projection of the second light emitting control signal line on the base substrate, which can avoid interference between the first light emitting control signal transmitted by the first light emitting control signal line and the second light emitting control signal transmitted by the second light emitting control signal line, ensuring stable transmission of the light emitting control signal.

When the display device provided by the embodiment of the present disclosure includes the above-mentioned display substrate, it also has the above-mentioned beneficial effects, which will not be described again here.

It should be noted that the signal line extending along the X direction means that the signal line includes a main portion and a secondary portion connected to the main portion. The main portion is a line, line segment or bar-shaped body, and the main portion extends along the X direction., and the length of the main portion extending along the X direction is greater than the length of the secondary portion extending along the other directions.

It should be noted that the "same layer" in the embodiments of the present disclosure may refer to film layers on the same structural layer. For example, the film layers on the same layer may be a layer structure formed by using the same film formation process to form a film layer for forming a specific pattern, and then using the same mask to pattern the film layer through a patterning process. Depending on the specific pattern, a patterning process may include multiple exposure, development or etching processes, and the specific pattern in the formed layer structure may be continuous or discontinuous. These specific patterns may also be at different heights or have different thicknesses.

In the various method embodiments of the present disclosure, the serial numbers of each step cannot be configured to limit the order of each step. For those of ordinary skill in the art, the sequence of each step can be changed without creative work. It is also within the protection scope of the present disclosure.

It should be noted that each embodiment in this disclosre is described in a progressive manner, and the same and similar parts between the various embodiments can be referred to each other. Each embodiment focuses on its differences from other embodiments. In particular, the method embodiments are described simply because they are basically similar to the product embodiments. For relevant details, the description of the product embodiments may be referred.

Unless otherwise defined, technical terms or scientific terms used in this disclosure shall have the usual meaning understood by a person with ordinary skill in the art to which this disclosure belongs. "First", "second" and similar words used in this disclosure do not indicate any order, quantity or importance, but are only configured to distinguish different components. Words such as "include" or "comprising" mean that the elements or things appearing before the word include the elements or things listed after the word and their equivalents, without excluding other elements or things. Words such as "connected," "coupled" are not limited to physical or mechanical connections, but may include electrical connections, whether direct or indirect. "Up", "down", "left", "right", etc. are only configured to express relative positional relationships. When the absolute position of the described object changes, the relative positional relationship may also change accordingly.

It will be understood that when an element such as a layer, film, region or substrate is referred to as being "on" or "under" another element, it can be "directly on" or "under" the other element, or intermediate elements may be present.

In the above description of the embodiments, specific features, structures, materials or characteristics may be combined in any suitable manner in any one or more embodiments or examples.

The above descriptions are implementations of the present disclosure. It should be pointed out that those skilled in the art can make some improvements and modifications without departing from the principle of the present disclosure. These improvements and modifications shall also fall within the scope of the present disclosure.

## Claims

1. A display substrate, comprising: a base substrate, a power line, a first light emitting control signal line, a second light emitting control signal line and a plurality of sub-pixels all arranged on the base substrate; wherein the sub-pixel includes a sub-pixel driving circuit and a light emitting element, the sub-pixel driving circuit includes a driving transistor, a power control transistor and a light emitting control transistor;
a gate electrode of the power control transistor is coupled to a corresponding first light emitting control signal line, a first electrode of the power control transistor is coupled to a corresponding power line, and a second electrode of the power control transistor is coupled to a first electrode of the driving transistor, a gate electrode of the light emitting control transistor is coupled to a corresponding second light emitting control signal line, and a first electrode of the light emitting control transistor is connected to a second electrode of the driving transistor, and a second electrode of the light emitting control transistor is coupled to the light emitting element;
the first light emitting control signal line includes at least part extending along a first direction, the second light emitting control signal line includes at least part extending along the first direction, and an orthographic projection of the first light emitting control signal line on the base substrate and an orthographic projection of the second light emitting control signal line on the base substrate are arranged along a second direction, and the second direction intersects the first direction.

2. The display substrate according to claim 1, wherein the power control transistor includes a power control active layer, the light emitting control transistor includes a light emitting control active layer, and the power control active layer and the light emitting control active layer are arranged along the first direction.

3. The display substrate according to claim 2, wherein in a layout area of a same sub-pixel driving circuit, at least part of the orthographic projection of the first light emitting control signal line on the base substrate is located between an orthographic projection of the gate electrode of the driving transistor on the base substrate and the orthographic projection of the second light emitting control signal line on the base substrate.

4. The display substrate according to claim 2, wherein at least part of an orthographic projection of the gate electrode of the power control transistor on the base substrate, and/or, at least part of an orthographic projection of the gate electrode of the light emitting control transistor on the base substrate is located between the orthographic projection of the first light emitting control signal line on the base substrate and the orthographic projection of the second light emitting control signal line on the base substrate.

5. The display substrate according to claim 1, wherein the display substrate further includes a first scanning line and a data line; the sub-pixel driving circuit includes a data writing-in transistor, a gate electrode of the data writing-in transistor is coupled to a corresponding first scanning line, a first electrode of the data writing-in transistor is coupled to a corresponding data line, and a second electrode of the data writing-in transistor is coupled to the first electrode of the driving transistor;
in a layout area of a same sub-pixel driving circuit, at least part of an orthographic projection of the first scanning line on the base substrate is located between the orthographic projection of the first light emitting control signal line on the base substrate and the orthographic projection of the second light emitting control signal line on the base substrate.

6. The display substrate according to claim 5, wherein the orthographic projection of the first scanning line on the base substrate does not overlap the orthographic projection of the first light emitting control signal line on the base substrate; and/or, the orthographic projection of the first scanning line on the base substrate does not overlap the orthographic projection of the second light emitting control signal line on the base substrate.

7. The display substrate according to claim 5, wherein the data writing-in transistor includes a data writing-in active layer, the power control transistor includes a power control active layer, and the driving transistor includes a driving active layer; a first end of the data writing-in active layer, a first end of the power control active layer and a first end of the driving active layer are coupled to each other to form a second node portion;
at least part of the data writing-in active layer and at least part of the power control active layer are located on a same side of the driving active layer along the second direction.

8. The display substrate according to claim 7, wherein the sub-pixel driving circuit further includes a storage capacitor, a first electrode plate of the storage capacitor is coupled to the gate electrode of the driving transistor, and a second electrode plate of the storage capacitor is coupled to the power line;
the second electrode plate includes an electrode plate main portion and an electrode plate extension portion coupled to each other, an orthographic projection of the electrode plate main portion on the base substrate partially overlaps an orthographic projection of the first electrode plate on the base substrate, an orthographic projection of the electrode plate extension portion on the base substrate does not overlap the orthographic projection of the first electrode plate on the base substrate, the orthographic projection of the electrode plate extension portion on the base substrate at least partially overlaps an orthographic projection of the second node portion on the base substrate.

9. The display substrate according to claim 8, wherein
the orthographic projection of the electrode plate extension portion on the base substrate partially overlaps the orthographic projection of the first light emitting control signal line on the base substrate, and does not overlap the orthographic projection of the second light emitting control signal line on the base substrate.

10. The display substrate according to claim 8, wherein the sub-pixel driving circuit further includes a first conductive connection portion, and the first conductive connection portion is respectively connected to the first electrode of the power control transistor, the electrode plate extension portion and the power line; an orthographic projection of the first conductive connection portion on the base substrate does not overlap the orthographic projection of the electrode plate main portion on the base substrate.

11. The display substrate according to claim 1, wherein the power line includes at least part extending along the second direction; there is a first overlapping area between the orthographic projection of the power line on the base substrate and the orthographic projection of the first light emitting control signal line on the base substrate, and there is a second overlapping area between the orthographic projection of the power line on the base substrate and the orthographic projection of the second light emitting control signal line on the base substrate;
a length of the first overlapping area along the first direction is greater than a length of the second overlapping area along the first direction.

12. The display substrate according to claim 1, wherein the first light emitting control signal line and the gate electrode of the power control transistor are arranged in different layers; and/or, the second light emitting control signal line and the gate electrode of the light emitting control transistors are arranged in different layers.

13. The display substrate according to claim 11, wherein the display substrate further includes a first source-drain metal layer, the first light emitting control signal line and/or the second light emitting control signal line, and the first source-drain metal layers are arranged in a same layer and made of a same material.

14. The display substrate according to claim 1, wherein the display substrate further comprises a first initialization signal transmission layer, the first initialization signal transmission layer includes a plurality of first initialization transmission portions and a plurality of second initialization transmission portions, an extension direction of the first initialization transmission portions intersects an extension direction of the second initialization transmission portion;
at least part of the sub-pixel driving circuit also includes a first reset transistor and a second conductive connection portion, the second conductive connection portion is respectively coupled to a first electrode of the first reset transistor, a corresponding first initialization transmission portion and a corresponding second initialization transmission portion; a second electrode of the first reset transistor is coupled to the gate electrode of the driving transistor.

15. The display substrate according to claim 14, wherein the display substrate further includes a second initialization signal transmission layer, the second initialization signal transmission layer includes a plurality of third initialization transmission portions and a plurality of fourth initialization transmission portions, an extension direction of the third initialization transmission portion intersects an extension direction of the fourth initialization transmission portion;
at least part of the sub-pixel driving circuit also includes a second reset transistor and an eighth conductive connection portion, the eighth conductive connection portion is respectively coupled to the a electrode of the second reset transistor, a corresponding third initialization transmission portion and a corresponding fourth initialization transmission portion; a second electrode of the second reset transistor is coupled to the light emitting element.

16. The display substrate according to claim 15, wherein the display substrate further includes a cathode layer and a plurality of first cathode compensation lines, the first cathode compensation line includes at least part extending along the second direction, the plurality of the first cathode compensation lines are respectively coupled to the cathode layer.

17. The display substrate according to claim 16, wherein the first initialization transmission portion and the third initialization transmission portion are alternately arranged along the second direction; and/or
the second initialization transmission portions and the fourth initialization transmission portions are alternately arranged along the first direction; and/or,
at least part of the first cathode compensation line is located between adjacent second initialization transmission portion and fourth initialization transmission portion.

18. The display substrate according to claim 17, wherein the display substrate includes a plurality of power lines and a plurality of data lines;
the second initialization transmission portion is located between adjacent power line and data line; and/or the fourth initialization transmission portion is located between adjacent power line and data line; and/or, the first cathode compensation line is located between adjacent power supply line and data line;
the adjacent power line and data line are coupled to a same sub-pixel driving circuit.

19. The display substrate according to claim 16, wherein the display substrate further includes a plurality of second cathode compensation lines arranged along the second direction, and the second cathode compensation line includes at least part extending along the first direction, the second cathode compensation line is coupled to the first cathode compensation line.

20. The display substrate according to claim 19, wherein the display substrate further includes a plurality of power supply compensation lines, the power supply compensation line includes at least part extending along the first direction, the power supply compensation line is coupled to the power line; the power compensation line and the second cathode compensation line are alternately arranged along the second direction.

21. The display substrate according to claim 15, wherein the first reset transistor includes a first reset active layer, and the first reset active layer includes two first channel portions, and a first conductive portion respectively coupled to the two first channel portions; an orthographic projection of the first conductive portion on the base substrate at least partially overlaps an orthographic projection of the third initialization transmission portion on the base substrate.

22. The display substrate according to claim 14, wherein the sub-pixel driving circuit further includes a compensation transistor, and a first electrode of the compensation transistor is coupled to the second electrode of the driving transistor, a second electrode of the compensation transistor is coupled with the gate electrode of the driving transistor;
the compensation transistor includes a compensation active layer, the compensation active layer includes two second channel portions, and a second conductive portion respectively coupled to the two second channel portions; an orthographic projection of the second conductive portion on the base substrate at least partially overlaps the orthographic projection of the first initialization transmission portion on the base substrate.

23. A display device, comprising the display substrate according to any one of claims 1 to 22.
